# EUROPÄISCHE PATENTSCHRIFT

(11) **EP 0 648 070 B1**
(45) Veröffentlichungstag und Bekanntmachung des Hinweises auf die Patenterteilung: **10.09.1997**
(21) Anmeldenummer: 94115874.3
(22) Anmeldetag: 07.10.1994
(51) Int. Cl.: H05K 5/00, H02G 3/08

(54) **Anordnung zur mechanischen Verbindung von zumindest zwei nachrichtentechnischen Geräten**
Mechanical device for joining at least two communication apparatuses
Dispositif pour relier mécaniquement au moins deux appareils de télécommunication

(30) Priorität: 11.10.1993 DE 9315359 U
(43) Veröffentlichungstag der Anmeldung: 12.04.1995
(73) Patentinhaber: SIEMENS AKTIENGESELLSCHAFT, 80333 München (DE)
(72) Erfinder: Grassl, Erwin, D-82541 St. Heinrich (DE); Luger, Johann, D-80999 München (DE); Trummer, Frank Dipl.-Ing., D-46282 Dorsten (DE)

(56) Entgegenhaltungen:
- DE-U- 1 987 192
- DE-U- 8 909 681
- US-A- 3 927 785

## Beschreibung

Die vorliegende Erfindung betrifft eine mechanische Verbindung von zumindest zwei nebeneinander angeordneten nachrichtentechnischen Geräten.

Zur Verbindung von zwei nachrichtentechnischen Geräten ist es bekannt, ein zumeist streifenförmiges Blech zu verwenden, das mit Ansätzen in taschenförmige Aufnahmen in der Bodenwanne der Geräte einschiebbar und in Führungen in der Bodenwanne gehaltert ist. An der Bodenwanne der Geräte sind weiterhin keilförmige Rastnasen vorgesehen, die im verbundenen Zustand der Geräte verrastend in das Verbindungsblech eingreifen.

Eine weitere Verbindung von nebeneinander angeordneten Geräten ist aus DE-U-8 909 681 bekannt.

Derart aufgebaute Verbindungen haben den Nachteil, daß sie nur mit großem Aufwand gelost werden können, wobei zusätzlich die Gefahr besteht, daß das Blech zum Lösen der Rastverbindung verbogen wird bzw. die Rastnasen beschädigt werden, so daß ein erneutes Verbinden der Geräte nicht mehr möglich ist.

Der vorliegenden Erfindung liegt daher die Aufgabe zugrunde, eine mechanische Verbindung von zwei nachrichtentechnischen Geräten aufzuzeigen, die vom Benutzer der Geräte in einfacher Weise durchgeführt werden kann, wobei zusätzlich die Möglichkeit bestehen soll, diese Verbindung im Bedarfsfall wieder zu lösen.

Gemäß der Erfindung wird diese Aufgabe dadurch gelöst, daß in einander benachbarten Randbereichen der Geräte in dem ersten Gerät Führungs- und Rastelemente vorgesehen sind, die mit im zweiten Gerät angeordneten und ihnen formmäßig entsprechenden Aufnahmen und Gegenrasten lösbar verbunden sind.

Durch eine derartige Gestaltung der jeweiligen Randbereiche werden die Geräte durch einen Rastvorgang miteinander verbunden, wobei die Führungsmittel dazu beitragen, eine spielfreie Verbindung der beiden Geräte herzustellen. Dabei können die Führungsmittel durch Haltestege und die Rastmittel durch Rasthaken gebildet werden, die jeweils mit einem durchgehenden Ansatz des Gerätes U-förmige Aufnahmen bilden. In diese U-förmigen Aufnahmen können abgewinkelte Bereiche der Gehäuseoberteile beider Gerate eingreifen. Hierbei besteht die Möglichkeit, daß die Rasthaken in Aufnahmen eingreifen, die beispielsweise durch Raststege begrenzt werden.

Gemäß einer bevorzugten Ausführungsform kann die Anordnung zum Verbinden von zwei Geräten so aufgebaut sein, daß das jeweilige Gerät aus einer Bodenwanne und einem mit der Bodenwanne verbundenen Gehäuseoberteil besteht, wobei an der Bodenwanne in deren Randbereich die Haltestege und die Rasthaken angeordnet sind, während das Gehäuseoberteil abgewinkelte Endbereiche aufweist, die im zusammengesetzten Zustand der Geräte in die genannten U-förmigen Aufnahmen eingreifen.

Die Erfindung soll im folgenden anhand eines Ausführungsbeispieles näher erläutert werden.

Es zeigt
Figur 1 einen Randbereich eines nachrichtentechnischen Gerätes in einer teilweise geschnittenen perspektivischen Ansicht,
Figur 2 eine geschnittene Aufsicht auf zwei miteinander verbundene nachrichtentechnische Geräte,
Figur 3 eine vergrößerte Detailansicht des Kreisausschnittes A in Figur 2,
Figur 4 eine weitere geschnittene Aufsicht auf zwei miteinander verbundene nachrichtentechnische Geräte,
Figur 5 eine vergrößerte Detailansicht des Kreisausschnittes B in Figur 4.

Zwei nachrichtentechnische Geräte 1 und 2 sollen durch einfache Mittel miteinander verbunden werden. Diese Verbindung erfolgt durch in ihren Randbereichen vorgesehene Führungs- und Rastmittel.

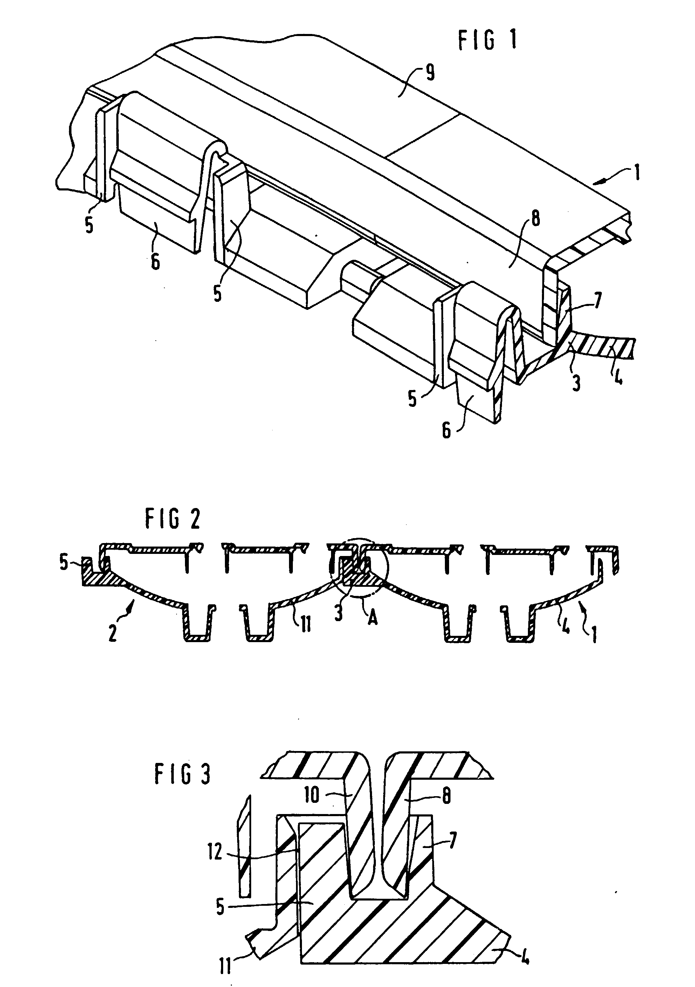

Wie der Figur 1 entnommen werden kann, weist ein Randbereich der Bodenwanne 4 des Gerätes 1 in bestimmten Abständen zueinander angeordnete mehrere Führungselemente in Form von Haltestegen 5 und Rastelemente in Form von verformbaren Rasthaken 6 auf, wobei nur ein Teil dieser Führungs- und Rastelemente gezeigt ist. Die Haltestege 5 und Rasthaken 6 sind einstückig mit der Bodenwanne 4 verbunden und sind zu einem durchgehenden Ansatz 7 der Bodenwanne 4 beabstandet angeordnet, so daß sich in diesen die Haltestege 5 und Rasthaken 6 aufweisenden Bereichen U-förmige Aufnahmen bilden. In diese U-förmige Aufnahmen greift ein abgewinkelter Endbereich 8 des Gehäuseoberteils 9 im zusammengebauten Zustand des Gerätes ein.

In den Figuren 2 und insbesondere 3 ist die Aufnahme des Endbereiches 8 vom Oberteil 9 des Gerätes 1 sowie des Endbereiches 10 vom Oberteil 13 des Gerätes 2 im U-förmigen Bereich der Haltestege 5 dargestellt. Hierbei liegt die Bodenwanne 11 des Gerätes 2 an dem freien Ende 12 des Haltesteges 5 vom Gerät 1 an, so daß eine spielfreie Verbindung der Geräte 1 und 2 in diesem Bereich erzielt ist.

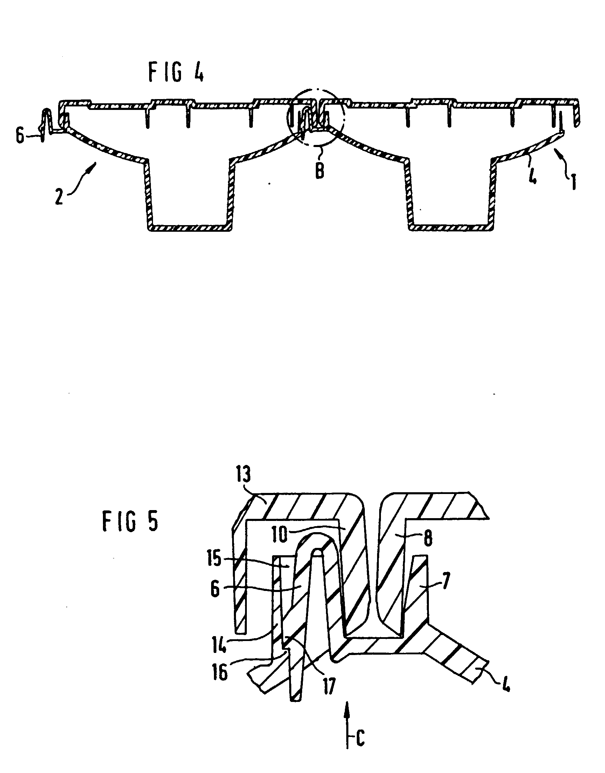

In der Figur 4 und insbesondere 5 ist die Aufnahme des Endbereiches 8 vom Gehäuseoberteil 9 des Gerätes 1 und des Endbereiches 10 des Gehäuseoberteiles 13 des Gerätes 2 im U-förmigen Bereich des am Gerät 1 angeordneten Rasthakens 6 gezeigt. Dieser wie auch die übrigen Rasthaken 6 befinden sich jeweils zwischen den Haltestegen 5 am Gerät 1. Das Gerät 2 weist in diesem Bereich eine durch einen Raststeg 14 gebildete und von der Bodenwanne 11 frei zugängliche Aufnahme 15 auf, wobei der Raststeg 14 die Rastnase 16 besitzt.

Beim Zusammenfügen der Geräte 1 und 2 wird das den Rasthaken 6 aufweisende Gerät 1 in der Pfeilrichtung C in das die Aufnahme 15 besitzende Gerät 2 eingebracht, wobei der Rasthaken 6 im eingeschobenen Zustand mit seinem Rastansatz 17 die Rastnase 16 am Raststeg 14 hintergreift. Dabei ist der Rasthaken 6 bezüglich seiner freien Länge so bemessen, daß er von der Bodenwanne 11 des Gerätes 2 her wieder zusammengedrückt werden kann, so daß sich die Rastverbindung auf einfache Weise lösen läßt.

## Patentansprüche

1. Anordnung mit zumindest zwei nebeneinander angeordneten, mechanisch miteinander verbundenen nachrichtentechnischen Gerärten (1,2), **dadurch gekennzeichnet**, daß in einander benachbarten Randbereichen (3) der Geräte (1, 2) in dem ersten Gerät (1) Führungs- und Rastelemente (5, 6) vorgesehen sind, die mit im zweiten Gerät (2) angeordneten und ihnen formmäßig entsprechenden Aufnahmen (15) und Gegenrasten lösbar verbunden sind.

2. Anordnung nach Anspruch 1, **dadurch gekennzeichnet,** daß die Führungselemente durch Haltestege (5) und die Rastelemente durch Rasthaken (6) gebildet werden, die jeweils mit einem durchgehenden Ansatz (7) des Gerätes (1) U-förmige Aufnahmen bilden.

3. Anordnung nach Anspruch 2, **dadurch gekennzeichnet**, daß in die U-förmigen Aufnahmen abgewinkelte Bereiche (8, 10) der Gehäuseteile beider Geräte (1, 2) eingreifen.

4. Anordnung nach Anspruch 1, **dadurch gekennzeichnet**, daß die Rasthaken (6) in Aufnahmen (15) eingreifen, die durch Raststege (14) begrenzt werden.

5. Anordnung nach Anspruch 1, **dadurch gekennzeichnet,** daß das jeweilige Gerät (1, 2) aus einer Bodenwanne (4, 11) und einem mit der Bodenwanne (4, 11) verbundenen Gehäuseoberteil (9) besteht, wobei an der Bodenwanne (4, 11) in deren Randbereich (3) die Haltestege (5) und die Rasthaken (6) angeordnet sind, während das Gehäuseoberteil (9) abgewinkelte Endbereiche (8, 10) aufweist, die im zusammengesetzten Zustand der Geräte (1, 2) in die genannten U-förmigen Aufnahmen eingreifen.

6. Anordnung nach Anspruch 2, **dadurch gekennzeichnet**, daß die Rasthaken (6) jeweils zwischen Haltestegen (5) vorgesehen sind.

## Claims

1. Arrangement having at least two telecommunications devices (1, 2) which are arranged next to one another and are mechanically connected to one another, characterized in that there are provided, in mutually adjacent edge regions (3) of the devices (1, 2) in the first device (1) guide and catch elements (5, 6), which are detachably connected to receptacles (15) and mating catches which are arranged in the second device (2) and correspond to the said guide and catch elements (5, 6) in terms of shape.

2. Arrangement according to Claim 1, characterized in that the guide elements are formed by retaining webs (5) and the catch elements are formed by catch hooks (6) which form U-shaped receptacles in each case with a continuous projection (7) of the device (1).

3. Arrangement according to Claim 2, characterized in that angled regions (8, 10) of the housing components of the two devices (1, 2) engage in the U-shaped receptacles.

4. Arrangement according to Claim 1, characterized in that the catch hooks (6) engage in receptacles (15) which are bounded by catch webs (14).

5. Arrangement according to Claim 1, characterized in that the respective device (1, 2) comprises a bottom pan (4, 11) and an upper housing component (9) which is connected to the bottom pan (4, 11), the retaining webs (5) and catch hooks (6) being arranged on the bottom pan (4, 11) in the edge region (3) while the upper housing part (9) has angled end regions (8, 10) which, in the assembled state of the devices (1, 2) engage in the aforesaid U-shaped receptacles.

6. Arrangement according to Claim 2, characterized in that the catch hooks (6) are provided between retaining webs (5) in each case.

## Revendications

1. Dispositif avec au moins deux appareils de télécommunication placés l'un à côté de l'autre et assemblés mécaniquement l'un à l'autre **caractérisé par le fait** que, dans les zones marginales (3) voisines des appareils (1, 2), des éléments de guidage et des éléments d'enclenchement (5, 6) sont prévus dans le premier appareil (1), ces éléments s'engageant d'une façon amovible dans des logements et des contre-enclenchements prévus dans le deuxième appareil et dont la forme correspond à celle des dits éléments.

2. Dispositif conforme à la revendication 1 **caractérisé par le fait** que les éléments de guidage sont formés par des entretoises de retenue (5) et les éléments d'enclenchement, par des crochets d'arrêt (6) qui forment chacun, avec un épaulement continu (7) de l'appareil (1), des logements en forme de U

3. Dispositif conforme à la revendication 2 **caractérisé par le fait** que des zones pliées (8, 10) des parties du coffret des deux appareils (1, 2) s'engagent dans les logements en forme de U.

4. Dispositif conforme à la revendication 1 **caractérisé par le fait** que les crochets d'arrêt (6) s'accrochent dans les logements (15) qui sont limités par les entretoises de retenue (14).

5. Dispositif conforme à la revendication 1 **caractérisé par le fait** que chaque appareil (1, 2) est composé d'une embase (4, 11) et d'une partie supérieure (9) de coffret d'appareil reliée avec l'embase (4, 11), les entretoises de retenue (5) et les crochets d'arrêt (6) étant placés sur l'embase (4, 11) dans sa zone marginale (3) alors que la partie supérieure du coffret (9) comporte des zones terminales pliées (8, 10) qui, dans la position d'assemblage des appareils (1, 2), s'accrochent dans les dits logements en forme de U.

6. Dispositif conforme à la revendication 2 **caractérisé par le fait** que les ressorts d'arrêt (6) sont prévus entre chaque entretoise de retenue (5).
